# DEMANDE DE BREVET EUROPEEN

(11) **EP 2 485 246 A2**
(43) Date de publication de la demande: **08.08.2012**
(21) Numéro de dépôt: 12153832.6
(22) Date de dépôt: 03.02.2012
(51) Int. Cl.: H01L 21/02, H01L 49/02, C23C 16/40, C23C 16/455, H01L 21/314, H01L 21/316

(54) **Procédé de fabrication et de réoxydation d'un condensateur TiN/Ta2O5/TiN**

(30) Priorité: 04.02.2011 FR 1150923
(71) Demandeur: STMicroelectronics (Crolles 2) SAS, 38920 Crolles (FR)
(72) Inventeur: Gros-Jean, Mickaël, 38000 GRENOBLE (FR)
(74) Mandataire: de Beaumont, Michel

(57) **Abrégé**

L'invention concerne un procédé de fabrication d'un condensateur TiN/Ta₂O₅/TiN comprenant les étapes suivantes :
former une couche de Ta₂O₅ sur un support de TiN par un processus de dépôt de couches atomiques assisté par plasma, PEALD ; et
soumettre la structure obtenue à un plasma de N₂O pendant une durée suffisante pour oxyder la couche de Ta₂O₅ sans oxyder le support de TiN.

## Description

### Domaine de l'invention

La présente invention concerne la fabrication d'un condensateur TiN/Ta₂O₅/TiN et plus particulièrement un procédé de réoxydation de la couche de Ta₂O₅ après sa formation sur un support de TiN.

### Exposé de l'art antérieur

Des condensateurs de type TiN/Ta₂O₅/TiN se sont développés ces dernières années, notamment parce qu'ils sont compatibles avec la fabrication des niveaux de métallisation d'un circuit intégré et que, en raison de la constante diélectrique élevée du Ta₂O₅, ils peuvent avoir des capacités élevées pour de petites surfaces. De tels condensateurs sont par exemple utilisés pour constituer les condensateurs de points mémoire de type DRAM, de filtres radiofréquence, ou de convertisseurs analogiques-numériques.

Parmi les procédés de formation de tels condensateurs, on a proposé, pour l'élaboration de la couche de Ta₂O₅, un procédé de dépôt de couches atomiques assisté par plasma, ce procédé étant couramment désigné par l'appellation PEALD (de l'anglais Plasma-Enhanced Atomic Layer Deposition).

Ce procédé consiste à alterner des phases de dépôt de tantale à partir d'un précurseur, couramment le produit dit TBTDET à savoir du tertiobutylimido-tris-diéthylamino tantale, et des phases d'application d'un plasma d'oxygène. Ensuite une électrode supérieure de TiN est déposée par tout procédé adapté.

Parmi les qualités que l'on attend d'un condensateur, on souhaite notamment qu'il présente un courant de fuite aussi faible que possible, de préférence inférieur à 10⁻⁷ A/cm². On cherche également à minimiser le facteur de relaxation diélectrique. Ce facteur de relaxation, FR, caractérise la variation de capacité d'un condensateur en fonction de la fréquence et est défini par la relation FR = [C(1kHz) - C(10kHz)]/C. Ainsi, ce facteur caractérise la variation de capacité d'un condensateur entre un fonctionnement à une fréquence de 1 kilohertz et un fonctionnement à une fréquence de 10 kilohertz. Physiquement, ce facteur est lié à la présence de dipôles dans le diélectrique et au temps de relaxation de ces dipôles.

Diverses normes fixent les valeurs souhaitées du facteur de relaxation. Les normes actuelles imposent que ce facteur de relaxation soit, en pourcent, inférieur à 0,2 pour un fonctionnement d'un condensateur à 25°C et inférieur à 0,6 pour un fonctionnement d'un condensateur à 125°C.

Pour obtenir de telles caractéristiques de courant de fuite et le facteur de relaxation diélectrique, la demanderesse a proposé :
- pendant tout le processus de PEALD, de limiter la température dans une plage de 200 à 250°C,
- pendant les étapes de dépôt de tantale à partir de TBTDET, de limiter la pression partielle de TBTDET dans une plage de 0,05 à 5 Pa, de préférence de 0,5 à 2 Pa, de préférence de l'ordre de 1 Pa à 10 % près, et
- pendant les phases d'application d'un plasma d'oxygène, de limiter la pression partielle d'oxygène dans une plage de 1 à 2000 Pa, de préférence de 10 à 30 Pa, de préférence à 25 Pa à 10 % près.

La demanderesse a montré qu'il résulte de ces choix des résultats optimisés en ce qui concerne le courant de fuite et le facteur de relaxation diélectrique.

Après les étapes de formation de la couche de Ta₂O₅ sur un support de TiN, on constate qu'il demeure inévitablement encore certains défauts et notamment des lacunes d'oxygène.

Il est connu que pour améliorer l'état de la couche de Ta₂O₅, il est souhaitable de procéder à une réoxydation en fin de processus.

Toutefois, l'expérience montre que les réoxydations effectuées jusqu'à présent fournissent des résultats très inhomogènes et peuvent même dégrader certaines caractéristiques, notamment le courant de fuite ou le facteur de relaxation diélectrique du condensateur finalement obtenu. De plus dans le cas de l'intégration de structures MIM (Métal-Isolant-Métal) au niveau des interconnections d'un circuit, la température de traitement doit être inférieure à 400°C, voir inférieure à 350°C pour préserver l'intégrité des interconnexions.

Ainsi, il existe un besoin pour améliorer le processus de réoxydation d'une couche de Ta₂O₅ dans un condensateur de type TiN/Ta₂O₅/TiN.

### Résumé

Un objet d'un mode de réalisation de la présente invention est de prévoir un procédé de réoxydation d'une couche de Ta₂O₅ formée sur un support de TiN qui procure une amélioration de toutes les caractéristiques du condensateur finalement obtenu et notamment qui diminue son courant de fuite et son facteur de relaxation diélectrique.

Un autre objet d'un mode de réalisation de la présente invention est de prévoir un condensateur optimisé.

Ainsi, un mode de réalisation de la présente invention prévoit un procédé de fabrication d'un condensateur TiN/Ta₂O₅/TiN comprenant les étapes suivantes :
former une couche de Ta₂O₅ sur un support de TiN par un processus de dépôt de couches atomiques assisté par plasma, PEALD ; et
soumettre la structure obtenue à un plasma de N₂O pendant une durée suffisante pour oxyder la couche de Ta₂O₅ sans oxyder le support de TiN.

Selon un mode de réalisation de la présente invention, pour déterminer ladite durée suffisante, on procède à des essais successifs et on effectue des coupes de la structure Ta₂O₅/TiN et des analyses de la composition de l'interface, pour déterminer la durée de traitement après laquelle toute la couche de Ta₂O₅ est réoxydée alors que le support de TiN et l'interface TiN/Ta₂O₅ ne sont pas atteints.

Selon un mode de réalisation de la présente invention, pendant l'application du plasma de N₂O, la température du substrat est maintenue entre 300 et 400°C.

Selon un mode de réalisation de la présente invention, la température du substrat est maintenue dans la plage de 370 à 390°C.

Selon un mode de réalisation de la présente invention, pendant l'oxydation par plasma, la pression partielle de N₂O est maintenue entre 10 et 3000 Pa.

Selon un mode de réalisation de la présente invention, pendant l'oxydation par plasma, la pression partielle de N₂O est maintenue entre 400 et 600 Pa.

Un mode de réalisation de la présente invention prévoit un condensateur TiN/Ta₂O₅/TiN dans lequel la zone d'interface entre la couche support de TiN et la couche de Ta₂O₅ a une épaisseur inférieure à 2 nm.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 représente une couche de Ta₂O₅ formée sur un support de TiN ; et
la figure 2 représente des courants de fuite d'un condensateur TiN/Ta₂O₅/TiN avant et après réoxydation selon un mode de réalisation de la présente invention.

### Description détaillée

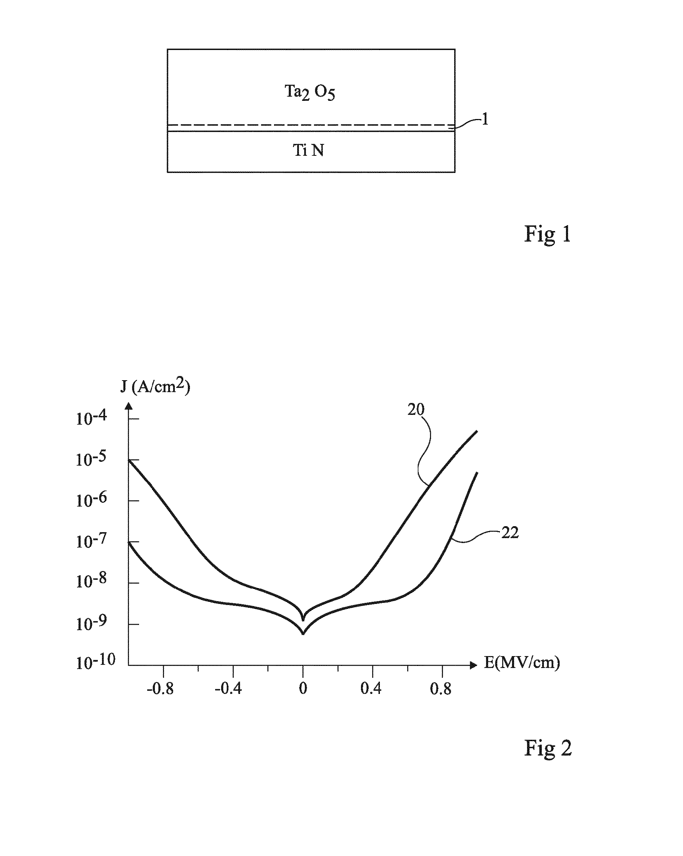

La figure 1 représente une couche de Ta₂O₅ obtenue par dépôt de couche atomique assisté par plasma sur un substrat de TiN. Il existe inévitablement une région d'interface 1 entre le TiN et le Ta₂O₅ comprenant des atomes de titane, de tantale, d'oxygène et d'azote dans des proportions diverses. Le procédé de dépôt de Ta₂O₅ sur TiN aura été réalisé pour minimiser l'épaisseur de cette couche.

Pour la réoxydation de la couche de Ta₂O₅, on utilise généralement des plasmas d'oxygène en présence d'argon mais l'effet de réoxydation dû aux radicaux d'oxygène est généralement contrebalancé par la présence d'argon qui est un réducteur pour le Ta₂O₅ et on ne réduit pas notablement le nombre de lacunes d'oxygène présentes dans la structure.

On est donc amené à utiliser des plasmas d'oxygène pur. L'inconvénient de ces plasmas est qu'ils sont inévitablement produits avec une puissance fournie au système de génération de plasma élevée et qu'ils sont extrêmement actifs, c'est-à-dire que des radicaux très énergétiques sont générés. Ainsi, la pénétration d'oxygène dans la couche de Ta₂O₅ est très peu contrôlable. Ou bien la pénétration n'est pas suffisante et la couche de Ta₂O₅ n'est pas suffisamment traitée sur toute son épaisseur. Ou bien l'oxygène pénètre jusqu'à la couche de TiN. Classiquement, ceci n'avait pas été considéré comme un inconvénient car les oxydes de titane constituent également un diélectrique à forte constante diélectrique.

Toutefois, la demanderesse a constaté que la présence de tels oxydes de titane et l'augmentation de l'épaisseur de la couche d'interface dégradait en fait les caractéristiques de courant de fuite et le facteur de relaxation diélectrique du condensateur finalement obtenu.

Ainsi, la demanderesse propose de réaliser une réoxydation de la couche de Ta₂O₅ qui s'arrête avec précision au niveau de l'interface Ta₂O₅/TiN. Pour atteindre ce résultat, la demanderesse propose d'utiliser un plasma oxydant, plus facile à produire avec une basse puissance fournie au système de génération de plasma qu'un plasma d'oxygène pur. Pour cela, la demanderesse propose d'utiliser un plasma de N₂O qui est beaucoup moins agressif qu'un plasma de O₂ pur. Ainsi, la pénétration de l'oxygène dans la couche de Ta₂O₅ est contrôlable (de 5 à 120 secondes pour une couche d'épaisseur 50 nm). On peut alors arrêter l'étape d'oxydation sous plasma quand la limite Ta₂O₅/TiN est atteinte.

En pratique, pour régler la machine, on procédera à des essais successifs et on effectuera des coupes de la structure Ta₂O₅/TiN et des analyses de la composition de l'interface. On peut ainsi déterminer l'instant auquel toute la couche de Ta₂O₅ est réoxydée alors que la couche de TiN et l'interface TiN/Ta₂O₅ ne sont pas atteintes. Une fois cet instant déterminé, la machine sera réglée pour fonctionner selon la durée résultant des essais précédents.

La figure 2 représente le courant de fuite en ampères par cm² en fonction du champ électrique appliqué en MV/cm pour une couche de Ta₂O₅ sur un substrat de TiN. La courbe 20 représente la densité de courant de fuite avant réoxydation et la courbe 22 la densité de courant de fuite après réoxydation. La densité de courant de fuite reste inférieure à 10⁻⁷ A/cm² dans la plage de champs électriques couramment utilisée, de -1 à +1 MV/cm. De plus, la demanderesse a observé que le facteur de relaxation diélectrique, après un traitement de réoxydation tel que décrit ci-dessus, est au moins aussi petit qu'avant ce traitement.

Un mode de réalisation particulier du processus de réoxydation consiste à utiliser une température de substrat de 300 à 400°C, de préférence voisine de 380°C à 5 % près. La pression de N₂O pur est de 10 à 3000 Pa, par exemple de 400 à 600 Pa, de préférence de 500 Pa à 10 % près. La puissance du plasma est maintenue à sa valeur minimale pour obtenir une ionisation des gaz plasmogènes.

L'utilisation du procédé décrit ici entraîne que l'épaisseur de la couche d'interface entre le Ta₂O₅ et le TiN est inférieure à 2 nm, après le traitement de réoxydation. Ainsi, la présente invention vise également le produit constitué d'un condensateur TiN/Ta₂O₅/TiN dans lequel l'épaisseur de la couche d'interface entre le Ta₂O₅ et le TiN est inférieure à 2 nm, après le traitement de réoxydation.

## Revendications

1. Procédé de fabrication d'un condensateur TiN/Ta₂O₅/TiN comprenant les étapes suivantes :
former une couche de Ta₂O₅ sur un support de TiN par un processus de dépôt de couches atomiques assisté par plasma, PEALD ; et
soumettre la structure obtenue à un plasma de N₂O pendant une durée suffisante pour oxyder la couche de Ta₂O₅ sans oxyder le support de TiN.

2. Procédé selon la revendication 1, dans lequel, pour déterminer ladite durée suffisante, on procède à des essais successifs et on effectue des coupes de la structure Ta₂O₅/TiN et des analyses de la composition de l'interface, pour déterminer la durée de traitement après laquelle toute la couche de Ta₂O₅ est réoxydée alors que le support de TiN et l'interface TiN/Ta₂O₅ ne sont pas atteints.

3. Procédé selon la revendication 1, dans lequel, pendant l'application du plasma de N₂O, la température du substrat est maintenue entre 300 et 400°C.

4. Procédé selon la revendication 3, dans lequel la température du substrat est maintenue dans la plage de 370 à 390°C.

5. Procédé selon la revendication 1, dans lequel pendant l'oxydation par plasma, la pression partielle de N₂O est maintenue entre 10 et 3000 Pa.

6. Procédé selon la revendication 5, dans lequel pendant l'oxydation par plasma, la pression partielle de N₂O est maintenue entre 400 et 600 Pa.

7. Condensateur TiN/Ta₂O₅/TiN dans lequel la zone d'interface entre la couche support de TiN et la couche de Ta₂O₅ a une épaisseur inférieure à 2 nm.
